Europäisches Patentamt

European Patent Office       (11) Publication number: **0 138 609**
                                                        A2
Office européen des brevets

(19)

## EUROPEAN PATENT APPLICATION

(12)

(21) Application number: **84307064.0**

(22) Date of filing: **16.10.84**

(51) Int. Cl.⁴: **C 08 L  15/00,** C 08 G  59/34, C 08 J  5/24 // (C08L15/00, 25:18, 61:06)

(30) Priority: **18.10.83 JP 193353/83**

(71) Applicant: **NIPPON OIL CO. LTD., 3-12, 1-chome Nishi Shimbashi, Minato-ku Tokyo (JP)**

(72) Inventor: **Hara, Hajime, 4-4-11, Fujigaya Kugenuma, Fujisawa-shi Kanagawa-ken (JP)**
Inventor: **Orii, Shingo, 340, Idanakano-cho Nakahara-Ku, Kawasaki-shi Kanagawa-ken (JP)**
Inventor: **Oshimi, Fumiaki, 422-6, Isogo-cho, Yokiohama-shi Kanagawa-ken (JP)**
Inventor: **Araki, Yoshihiko, 4-10-13, Minami-Yukigaya, Ohta-ku Tokyo (JP)**

(43) Date of publication of application: **24.04.85 Bulletin 85/17**

(74) Representative: **Silverman, Warren et al, HASELTINE LAKE & CO. Hazlitt House 28 Southampton Buildings Chancery Lane, London WC2A 1AT (GB)**

(84) Designated Contracting States: **DE FR GB**

(54) **Resin compositions for laminated boards.**

(57) A resin composition for use as a bonding agent in the preparation of laminated boards having excellent electrical properties and workability, which consists essentially of (1) an epoxidized butadiene polymer containing at least 0.3 mol of epoxy group per 100 g of the polymer and (2) a novolak type phenol resin and/or polyvinyl phenol.

EP 0 138 609 A2

- 1 -

RESIN COMPOSITIONS FOR LAMINATED BOARDS

This invention relates to a resin composition for use in the preparation of a laminated board having excellent electrical properties, particularly excellent dielectric properties, used for a circuit printed board made of glass fiber cloths or paper or the like.

With the high density packing of electronic on a circuit board, the speedup of signal transmission and the increasing utilization of high frequency waves in telecommunication, there have recently been raised problems as to a delay in signal transmission on a circuit board. Since the time of a delay in signal transmission increases in proportion to the square root of dielectric constant of circuit board materials, it has been sought that circuit printed boards for high-speed signal transmission electronic appliances have a low dielectric constant. The most widely used, epoxy resin-bonded laminates made of glass fiber cloths as the base material are disadvantageous as high-speed signal transmission electronic appliances or high frequency waves telecommunication appliances because of their considerably high dielectric constant of 4,5 - 5.

Butadiene polymers are widely used since they have excellent electrical properties such as, particularly, low dielectric constant and dielectric loss tangent as well as excellent humidity resistant and low water absorption, however, they will exhibit various undesirable drawbacks if they are used as a resin for laminated boards. In other words, in general, liquid butadiene polymers are a viscous liquid at ambient temperature as is self-evident from their name and prepregs made using them are tacky thereby rendering it very difficult to handle them during the laminate manufacturing process. If the prepregs are cured to the extent that their tackness is not appreciated, the butadiene polymers contained in the prepregs will almost entirely lose their fluidity when the prepregs are pressed together whereby it is impossible to effect satisfactory lamination. Generally, in many cases, butadiene polymers are cured by radical polymerization due to the double bonds contained therein. However, in the case of such radical polymerization, it is very difficult to stop the curing at the B stage and it is consequently hardly possible to obtain prepregs which have good storage stability without tackiness.

This invention was made in attempts to solve the above-mentioned problems and has for its object to provide a resin composition for use as a bonding agent in the preparation of laminated boards having excellent electrical properties and satisfactory workability.

The present inventors made intensive studies in attempt to attain said object and, as the result of their studies, they found that a resin composition consisting essentially of (1) an epoxidized butadiene polymer containing at least 0.3 mol of epoxy groups per 100 g of the polymer, obtained by the epoxidation of a liquid butadiene polymer containing at least 50 % of 1,2-bonds and (2) a novolak type phenol resin or polyvinyl phenol, will, when cured, be non-tacky in the state of prepregs containing the resin composition and will be satisfactory in fluidity and moldability when pressed to produce laminated boards from the prepregs. The thus produced laminated boards were found to have low dielectric constant and dielectric loss tangent, great insulation resistance, and excellent humidity resistance, chemical resistance and heat resistance. The present invention is based on this finding.

The resin composition of this invention consists essentially of

(1) an epoxidized butadiene polymer containing at least 0.3 mol of epoxy group per 100 g of the polymer, the epoxidized butadiene polymer being prepared by the epoxidation of a butadiene polymer containing at least 50 % of 1,2-bonds and

(2) a novolak type phenol resin or polyvinyl phenol as the curing agent.

The butadiene polymer used herein is a butadiene homopolymer or a butadiene copolymer containing at least 50 % of butadiene unit, each polymer having a number average molecular weight of usually 500 - 10,000, particularly 700 - 5,000.

At least 50 % of the butadiene units so contained is of the 1,2-bond type. The butadiene homopolymers and copolymers which are preferable, include those prepared by polymerizing butadiene alone, copolymerizing butadiene and a vinyl monomer such as butadiene or styrene, or copolymerizing diolefins such as butadiene or isoprene, in a hydrocarbon solvent using lithium, sodium or another alkali metal as the catalyst. The other polymers which are preferable, are those prepared by polymerizing or copolymerizing butadiene in a polar solvent such as tetrahydrofuran using naphthalene, anthracene or other polycyclic aromatic compounds as the activating agent and also using sodium or other alkali metals as the catalyst. In addition, there may also be likewise used so-called telechelic polymers prepared by introducing a hydroxyl, carboxyl and/or epoxy group is introduced into the terminal of said various polymers or copolymers.

The epoxidation of butadiene polymers may be effected by a known conventional epoxidation method. More specifically, the epoxidized butadiene polymers may be synthesized by allowing peracetic acid to act on butadiene polymers at ambient temperature to 100 C or by allowing hydrogen peroxide and acetic or formic acid to interact with each other in the reaction system thereby to evolve peracetic or performic acid and then reacting the thus evolved preacid with the butadiene polymers. The thus obtained epoxidized butadiene polymer should contain at least 0.3 mol, preferably 0.4 - 0.7 mol, of epoxy groups per 100 g of the polymer to produce excellent laminated boards.

The novolak type phenol resin or polyvinyl phenol will be detailed hereunder.

The novolak type phenol resin may be produced by a known conventional method which comprises reacting phenol, cresol or another alkylphenyl with formaldehyde in the presence of an acidic catalyst. This resin contains more than two aromatic nuclei. The polyvinylphenol may be obtained by polymerizing a vinylphenol such as p-vinylphenol, and poly-p-vinylphenol (for example, produced under the tradename of RESIN M by Maruzen Oil Co., Ltd.) in typical of the polyvinylphenol. The novolak type phenol resin or polyvinylphenol is usually used in an amount of 20 - 150, preferably 30 - 100, parts by weight per 100 parts by weight of the epoxidized butadiene polymer.

If necessary in this invention, there may be used a curing catalyst which preferably includes a tertiary amine such as N, N-dimethylbenzylamine, or an imidazole such as 2-ethyl-4-methylimidazole. Further, $BF_3$ or its complex of an organic acid or an amine, may also be used as a latent catalyst.

In the production of laminated boards using the resin composition of this invention, said resin composition is dissolved in a suitable organic solvent such as acetone or methyl ethyl ketone to obtain a varnish, substrates are impregnated with the thus obtained varnish and the thus impregnated substrates are dried to obtain prepregs for laminated boards. The substrates used herein include glass fiber-made non-woven cloths, glass fiber-made cloths, synthetic fiber-made non-woven cloths, synthetic fiber-made cloths, paper and cotton cloths. The prepregs so obtained are non-tacky and easy to handle without troubles.

Conventional hot presses may be used, as they are, in forming the prepregs into laminated boards according to this invention. The forming temperature, pressure and time may be in the ranges of 150 - 180°C, 20 - 100 Kg/cm$^2$ and 30 - 120 minutes, respectively. In a case where the prepregs are piled one upon another, a copper foil is laid on the surface of the prepreg and the whole is press molded, the resulting laminate is a copper-clad laminated board.

The laminated boards so obtained are excellent in electrical properties, particularly excellent dielectric properties in high frequency wave regions, and are also excellent in humidity resistance, chemical resistance and heat resistance.

The ingredient (1), an epoxidized butadiene polymer and the ingredient (2), a novolak resin or polyvinyl phenol, may be mixed together in a ratio by weight of 100 parts: 20 - 150 parts in the preparation of a resin composition of this invention.

The invention will be better understood by the following Examples wherein all the parts are by weight unless otherwise specified.

Example 1

Polybutadiene having 62% of 1,2 - bonds and a number average molecular weight of 1500 produced by Nippon Oil Company, Japan, was epoxidized to obtain an epoxidized butadiene polymer containing 0.5 mol of epoxy group per 100 g of the polymer. One hundred (100) parts of the thus obtained epoxidized butadiene polymer, 49 parts of a novolak type phenol resin (produced under the tradename of PS-2322 by Gun-ei Chemical Company) and 1.5 parts of 2-ethyl-4-methylimidazole, were dissolved in 149 parts of methyl ethyl ketone to obtain a varnish for impregnation. Glass fiber-made substrates (produced under the grade of H 7628-3E by Asahi Fiber Glass Company) were impregnated with the thus obtained varnish and dried at 150$^{O}$C for two minutes to obtain prepregs having no tackiness. Eight (8) sheets of the thus obtained prepregs were piled one upon another with an electrolytically manufactured copper foil (JTC foil, 35μm thick, produced by Nikko Gould Foil Co.) placed on one outermost surface of the thus piled prepregs, after which the whole was cured at 150$^{O}$C for 30 minutes and further at 170$^{O}$C for 90 minutes under the pressure of 30 Kg/cm$^2$and then post-cured at 180$^{O}$C for 60 minutes thereby to obtain a copper-clad laminated board.

Example 2

One hundred (100) parts of an epoxidized butadiene polymer (obtained from a polybutadiene having 62 % of 1.2 - bonds and a number average molecular weight of about 1500) containing 0.5 mol of epoxy groups per 100 g of the polymer, 60 parts of poly-p-vinylphenol (Tradename, Maruzen RESIN M; Number average molecular weight, 1700) and 1.5 parts of 2-ethyl-4-methylimidazole, were dissolved in 129 parts of methyl ethyl ketone to obtain a varnish for impregnation. Glass fiber-made substrates (produced under the grade of H 7628-3E by Asahi Fiber Glass Co.) were immersed in the thus obtained varnish and dried at 150°C for 4 minutes to obtain non-tacky prepregs. Eight (8) sheets of the thus obtained prepregs were piled one upon another with an electrolytically manufactured copper foil placed on one outermost surface of the piled prepregs and lamination molded at 150°C for 30 minutes and further at 170°C for 90 minutes under the pressure of 30 Kg/cm$^2$ into a copper-clad laminated board.

The copper-clad laminated boards obtained in Examples 1 and 2 were each measured in accordance with JIS C 6481 for their performance which were solder heat resistance, dielectric constant, dielectric loss constant, water absorbtion, volume resistivity and surface resistivity. The results are shown in Table 1. This Table also indicates the results measured on a commercially available G-10 class copper-clad laminated board for comparison.

Table 1

| Item | Unit | Treating condition | Example 1 | Example 2 | G-10 comp. Example |
|---|---|---|---|---|---|
| Solder heat resistance | Second | 260°C | At least 300 | At least 300 | At least 120 |
| Dielectric constant 1MHz | - | A | 3.6 | 3.6 | 4.8 |
| Dielectric loss tangent | - | A | $1.1 \times 10^{-2}$ | $1.1 \times 10^{-2}$ | $1.5 \times 10^{-2}$ |
| Volume resistivity | $\Omega \cdot cm$ | A | $4.3 \times 10^{15}$ | $0.9 \times 10^{15}$ | $1.9 \times 10^{15}$ |
| Surface resistivity | $\Omega$ | A | $4.9 \times 10^{15}$ | $0.76 \times 10^{15}$ | $5.6 \times 10^{15}$ |
| Water absorption | % | D-24/23 | 0.07 | 0.09 | 0.20 |
| Flexural strength | Kg/mm$^2$ | A | 45 | 40 | 53 |
| Flexural modulas | Kg/mm$^2$ | A | 1810 | 1860 | - |
| Peel strength | Kg/cm | A | 1.45 | 1.45 | 2.07 |

It is seen from Table 1 that the laminated boards using the resin composition of this invention therein are low in dielectric constant and water absorption and are excellent in heat resistance and electrical properties.

Example 3

A butadiene polymer (number average molecular weight, about 1800) containing 64 % of 1,2-bonds was epoxidized to obtain an epoxidized butadiene polymer containing 0.5 mol of epoxy group per 100 g of the polymer. One hundred (100) parts of the thus obtained epoxidized butadiene polymer, 43 parts of a novolak type phenol resin (produced under the tradename of BRM-594 by Showa Union Synthetic company) and 2 parts of 2-ethyl-4-ethylimidazole, were dissolved in 143 parts of methyl ethyl ketone to obtain a varnish for impregnation. Linter paper was immersed in the thus obtained varnish and dried at 150°C for 4 minutes to obtain a non-tacky prepreg having a 50-55 % impregnated resin content. Seven (7) sheets of the thus obtained prepregs were piled one upon another with a copper foil placed on one outermost surface of the piled prepregs, were press molded at 160°C and 100 Kg/cm$^2$ for 100 minutes to obtain a copper-clad laminated board which was then measured for performances in accordance with JIS C 6481 with the results being as indicated in Table 2. For comparison, Table 2 also indicates the results obtained with a commercially available FR3 class copper-clad laminated board.

0138609

Table 2

| Item | Unit | Treating Condition | Value measured | FR 3 Comp. Example |
|------|------|--------------------|----------------|---------------------|
| Solder heat resistance | Second | $260^{\circ}C$ | 120 | 15 |
| Peel strength | Kg/cm | A | 2.0 | 1.8 |
| Flexural strength | Kg/mm$^2$ | A | 12 (longitudinal) | 15 (longitudinal) |
| Flexural modulus | Kg/mm$^2$ | A | 600 | – |
| Insulation resistance | $\Omega$ | A | $1.0 \times 10^{13}$ | $1.2 \times 10^{13}$ |
| | | D–2/100 | $3.0 \times 10^{10}$ | $6.0 \times 10^{10}$ |
| Dielectric constant (1MHz) | – | A | 3.9 | 4.2 |
| | | D–48/50 | 4.4 | 4.5 |
| Dielectric loss tangent (1MHz) | – | A | 0.03 | 0.02 |
| | | D–48/50 | 0.05 | 0.04 |
| Water absorption | % | D–24/23 | 0.8 | 0.6 |

- 11-

Claims:

1. A resin composition for laminated boards which consists essentially of

(1) an epoxidized butadiene polymer containing at least 0.3 mol of epoxy group per 100 g of the polymer, prepared by epoxidating a butadiene polymer wherein at least 50 % of the butadiene units is of the 1,2-bonds type, and

(2) at least one member selected from the group consisting of novolak type phenol resins and polyvinyl phenol.

2. A resin composition according to claim 1, wherein the butadiene polymer is at least one member selected from the group consisting of a butadiene homopolymer and a butadiene copolymer containing at least 50 percent of butadiene units, each polymer having a number average molecular weight of 500 - 10,000.

3. A resin composition according to claim 1 or 2, wherein the epoxidized butadiene polymer (1) and the novolak resin or polyvinyl phenol (2) are present in a ratio by weight of 100 parts: 20 - 150 parts.